# EUROPÄISCHE PATENTANMELDUNG

(11) **EP 1 139 432 A2**
(43) Veröffentlichungstag der Anmeldung: **04.10.2001**
(21) Anmeldenummer: 01000068.5
(22) Anmeldetag: 23.03.2001
(51) Int. Cl.: H01L 29/872, H01L 21/329

(54) **Schottky-Diode**

(30) Priorität: 30.03.2000 DE 10015884
(71) Anmelder: Philips Corporate Intellectual Property GmbH, 52064 Aachen (DE); Koninklijke Philips Electronics N.V., 5621 BA Eindhoven (NL)
(72) Erfinder: Epke, Thomas, 52064, Aachen (DE)
(74) Vertreter: Volmer, Georg, Dipl.-Ing.

(57) **Zusammenfassung**

Die Erfindung betrifft ein Halbleiterbauelement, insbesondere eine Schottky-Hybrid-Diode mit Schutzring (S). Das Halbleiterbauelement weist ein Halbleitersubstrat (1), eine Epitaxieschicht (2), auf welcher eine Isolatorschicht (3) mit einer Öffnung (10) abgeschieden ist, mit einer die unter der Öffnung (10) liegende Epitaxieschicht (2) bedeckende Schottky-Metallschicht (9), mit einem in der Epitaxieschicht (9) befindlichen ringförmigen Halbleiterbereich (4) auf. Entlang der Außenkontur des Halbleiterbauelementes befindet sich in der Epitaxieschicht (2) ein Dotierungsbereich (6) und außerdem auf der Epitaxieschicht (2) eine Oxid-Schicht(8).

## Beschreibung

Die Erfindung betrifft ein Halbleiterbauelement ausgestattet mit einem Halbleitersubstrat mit einem Dotierstoff eines ersten Dotierungstyps mit einer Dotierungsdichte n1, auf dem eine Epitaxieschicht mit einem Dotierstoff eines ersten Dotierungstyps mit einer Dotierungsdichte n2 aufgebracht ist, auf welcher eine Isolatorschicht mit einer Öffnung abgeschieden ist, mit einer die unter der Öffnung liegende Epitaxieschicht bedeckende Schottky-Metallschicht, mit einem in der Epitaxieschicht befindlichen ringförmigen Halbleiterbereich mit einem Dotierstoff eines zweiten Dotierungstyps mit einer Dotierungsdichte n3, welcher an die Isolatorschicht und die Schottky-Metallschicht in einem den Metall-Isolator-Übergang umgebenden Bereich angrenzt und ein Verfahren zur Herstellung eines solchen Halbleiterbauelementes.

Schottky-Dioden sind Halbleiterbauelemente, die einen Metall-Halbleiter-Übergang als Grundstruktur aufweisen und deren grundsätzliche elektronischen Eigenschaften durch diesen Übergang bestimmt sind Eine Schottky-Diode besteht aus einer Halbleiter-Metall-Kombination, die so gewählt wird, dass sich an ihrer Grenzfläche eine Verarmungszone bildet. Das Strom-Spannungs-Verhalten dieser Anordnung hängt von der Richtung der anliegenden Spannung ab.

Obwohl sich das Wirkprinzip des Metall-Halbleiter-Überganges in einer Schottky-Diode grundsätzlich von dem eines pn-Überganges unterscheidet, sind die Kennlinien einer pn-Diode und einer Schottky-Diode ähnlich. Im Vergleich zu einer pn-Diode hat eine Schottky-Diode eine geringere Schleusenspannung und einen deutlich kleineren, aber stark temperaturabhängigen Sättigungsstrom. Außerdem weist eine Schottky-Diode eine Sperrschichtkapazität und keine Diffusionskapazität auf, durch sich kürzere Umschaltzeiten ergeben. Weiterhin ist das Durchbruchsverhalten im Sperrbereich zum Teil sehr ausgeprägt, weshalb die erreichbaren Durchbruchspannungen erheblich niedriger als bei pn-Dioden sind.

Zur Verbesserung und Erreichung eines definierten Durchbruchverhaltens einer Schottky-Diode wird in DE 197 05 728 A1 ein Schutzring eines zweiten Dotierungstyps in die Epitaxieschicht eines ersten Dotierungstyps eindiffundiert. Dieser Schutzring bewirkt, dass die Sperrspannung, die bei einer normalen Schottky-Diode niedrig ist, gegenüber dieser wesentlich erhöht wird. Dieser Effekt kommt dadurch zustande, dass der Verlauf der Feldlinien des Randfeldes der Metallelektrode, der Schottky-Metallschicht, dadurch linearisiert wird, dass es zumindest teilweise in dem ringförmigen Halbleiterbereich des zweiten Dotierungstyps endet.

Die durch eine Spezifikation festgelegten Eigenschaften eines Halbleiterbauelementes, werden durch die verwendeten Materialien, das Design des Halbleiterbauelementes und die Dotierungsprofile bestimmt.

Zur Herstellung eines Halbleiterbauelementes können zum Beispiel verschiedenste Aufwachs-, Implantations- und Diffusionsprozesse verwendet werden. Durch einen von der Spezifikation abhängigen Satz an Masken wird das Design eines Halbleiterbauelementes bestimmt. Jeder zusätzliche Fertigungsschritt bzw. Maskenschritt kostet aber viel Geld, da sich dadurch die Durchlaufzeit der Wafer durch die Fertigung erhöht und größerer Personal- und Maschineneinsatz notwendig sind.

Der Erfindung liegt die Aufgabe zugrunde, ein verbessertes Halbleiterbauelement bereitzustellen, welches mit einfachen Prozessen und mit möglichst wenig Prozessschritten herzustellen ist.

Die Aufgabe wird gelöst durch ein Halbleiterbauelement ausgsstattet mit einem Halbleitersubstrat mit einem Dotierstoff eines ersten Dotierungstyps mit einer Dotierungsdichte n1, auf dem eine Epitaxieschicht mit einem Dotierstoff eines ersten Dotierungstyps mit einer Dotierungsdichte n2 aufgebracht ist, auf welcher eine Isolatorschicht mit einer Öffnung abgeschieden ist, mit einer die unter der Öffnung liegende Epitaxieschicht bedeckende Schottky-Metallschicht, mit einem in der Epitaxieschicht befindlichen ringförmigen Halbleiterbereich mit einem Dotierstoff eines zweiten Dotierungstyps mit einer Dotierungsdichte n3, welcher an die Isolatorschicht und die Schottky-Metallschicht in einem den Metall-Isolator-Übergang umgebenden Bereich angrenzt, mit einem in der Epitaxieschicht befindlichen Dotierungsbereich mit einem Dotierstoff eines ersten Dotierungstyps mit einer Dotierungsdichte n4 und dem Dotierstoff eines zweiten Dotierungstyps mit einer Dotierungsdichte n3 entlang der Außenkontur des Halbleiterbauelementes und mit einer auf der Epitaxieschicht befindlichen, an die Isolatorschicht grenzende Oxid-Schicht entlang der Außenkontur des Halbleiterbauelementes.

Ein derartiges Halbleiterbauelement weist neben einem Schutzring zusätzlich einen Dotierungsbereich entlang der Außenkontur der Diode auf. Dieser Dotierungsbereich, auch Channel genannt, ist vorteilhaft, um sogenannte Channelströme zu verhindern. Diese Channelströme fließen zwischen Schutzring und Trennbahn, wenn das Halbleiterbauelement in Sperrrichtung gepolt ist.

Eine weitere vorteilhafte Ausbildung ist die Oxid-Schicht entlang der Außenkontur der Diode. Die Außenkontur entspricht auch der Trennbahn, die die einzelnen Halbleiterbauelemente auf dem Wafer abgrenzt. Die Oxid-Schicht in der Trennbahn verhindert beim Sägen, dass der Kristall am Rand zu stark ausbricht und beschädigt wird.

Es ist bevorzugt, dass die Dotierungsdichten n1 und n4 größer als die Dotierungsdichte n2 sind.

Es ist weiterhin bevorzugt, dass die Dotierungsdichte n4 größer als die Dotierungsdichte n3 ist.

Durch die unterschiedlichen Dotierungsdichten wird ein Dotierungsbereich, der Channel, in der Epitaxieschicht erhalten, der ein Durchbrechen des Halbleiterbauelementes schon bei kleinen Spannungen verhindert.

Es ist bevorzugt, dass das Material für das Halbleitersubstrat und die Epitaxieschicht Silicium enthält.

Silicium weist im Vergleich zu anderen halbleitenden Materialien wie z B. Germanium höhere zulässige Betriebstemperaturen auf.
Es ist weiterhin bevorzugt, dass der Dotierstoff eines ersten Dotierungstyps ausgewählt aus der Gruppe P, As und Sb ist.

Außerdem ist bevorzugt, dass der Dotierstoff eines zweiten Dotierungstyps ausgewählt aus der Gruppe B, Al und Ga ist.

Durch unterschiedliche Dotierungsprofile lassen sich verschiedenste Halbleiterbauelemente mit nichtlinearen Strom-Sparmungäkennlinien herstellen.

Es ist vorteilhaft, dass die Isolatorschicht und die Oxid-Schicht SiO₂ enthalten.

SiO₂ weist eine hohe chemische Widerstandsfähigkeit auf, hat eine geringe thermische Wärmeleitfähigkeit sowie einen hohen thermischen Ausdehnungskoeffizienten.

Es ist bevorzugt, dass die Schottky-Metallschicht ein Material ausgewählt aus der Gruppe Al, Mo, W, Pt, Pd, Ag, Au, Ti, Ni, NiFe und Kombinationen dieser Materialien enthält.

Mo, W, Pt, Pd, Ag, Au, Ni und Ti sind Metalle mit hoher Austrittsarbeit und diffundieren nicht in das Halbleitermaterial. Obwohl Aluminium kein Metall mit hoher Austrittsarbeit ist, weist Aluminium als Schottky-Metallschicht Vorteile bei hohen Spannungen auf.

Es ist bevorzugt, dass auf der Isolatorschicht und der Oxid-Schicht eine Schutzschicht aufgebracht ist.

Durch die Schutzschicht werden die darunterliegenden Schichten vor mechanischer Beanspruchung und Korrosion durch Feuchtigkeit geschützt.

Es ist ganz besonders bevorzugt, dass das Halbleiterbauelement eine Schottky-Diode ist.

Das Halbleiterbauelement ist eine sogenannte Schottky-Hybrid-Diode, da es einen Schutzring aufweist.

Desweiteren betrifft die Erfindung auch ein Verfahren zur Herstellung eines Halbleiterbauelementes ausgestattet mit einem Halbleitersubstrat mit einem Dotierstoff eines ersten Dotierungstyps mit einer Dotierungsdichte n1, auf dem eine Epitaxieschicht mit einem Dotierstoff eines ersten Dotierungstyps mit einer Dotierungsdichte n2 aufgebracht ist, auf welcher eine Isolatorschicht mit einer Öffnung abgeschieden ist, mit einer die unter der Öffnung liegende Epitaxieschicht bedeckende Schottky-Metallschicht, mit einem in der Epitaxieschicht befindlichen ringförmigen Halbleiterbereich mit einem Dotierstoff eines zweiten Dotierungstyps mit einer Dotierungsdichte n3, welcher an die Isolatorschicht und die Schottky-Metallschicht in einem den Metall-Isolator-Übergang umgebenden Bereich angrenzt, mit einem in der Epitaxieschicht befindlichen Dotierungsbereich mit dem Dotierstoff eines ersten Dotierungstyps mit einer Dotierungsdichte n4 und dem Dotierstoff eines zweiten Dotierungstyps mit einer Dotierungsdichte n3 entlang der Außenkontur des Halbleiterbauelementes und mit einer auf der Epitaxieschicht befindlichen, an die Isolatorschicht grenzende Oxid-Schicht entlang der Außenkontur des Halbleiterbauelementes, welches mindestens die Schritte
- Erzeugen einer Epitaxieschicht mit einem Dotierstoff eines ersten Dotierungstyps mit einer Dotierungsdichte n2 auf einem Halbleitersubstrat mit einem Dotierstoff eines ersten Dotierungstyps mit einer Dotierungsdichte n1,
- Abscheiden einer Isolatorschicht auf der Epitaxieschicht,
- Freilegen eines ringförmigen Bereichs und eines der Außenkontur des Halbleiterbauelementes angepassten Bereichs in der Isolatorschicht,
- Implantieren eines Dotierstoffes eines zweiten Dotierungstyps mit einer Dotierungsdichte n3 in die freigelegten Bereiche der Epitaxieschicht,
- Diffusion des Dotierstoffes eines zweiten Dotierungstyps in die Epitaxieschicht,
- Abscheiden einer Oxid-Schicht auf die freigelegten Bereiche der Epitaxieschicht,
- Implantieren eines Dotierstoffes eines ersten Dotierungstyps mit einer Dotierungsdichte n4 in die Oxid-Schicht,
- Freilegen einer Öffnung in der Isolatorschicht,
- Diffusion des Dotierstoffes eines ersten Dotierungstyps aus der Oxid-Schicht in die Epitaxieschicht,
- Abscheiden einer Schottky-Metallschicht und
- Trennen entlang der Außenkontur des Halbleiterbauelementes umfasst.
Das Verfahren hat den Vorteil, dass nur elf Prozessschritte mit insgesamt zwei Masken benötigt werden, um dieses Halbleiterbaudelement herzustellen. Dadurch können die Kosten für die Herstellung niedrig gehalten werden.

Es kann vorteilhaft sein, dass bevor die Schottky-Metallschicht abgeschieden wird, eine Schutzschicht auf der Isolatorschicht und der Oxid-Schicht abgeschieden wird.

Im folgenden soll die Erfindung anhand von vier Figuren und einem Ausführungsbeispiel erläutert werden. Dabei zeigen
- Fig. 1: im Querschnitt ein Halbleiterbauelement und
- Fig. 2 bis Fig. 4: ein Flow-Chart zur Herstellung eines Halbleiterbauelementes.

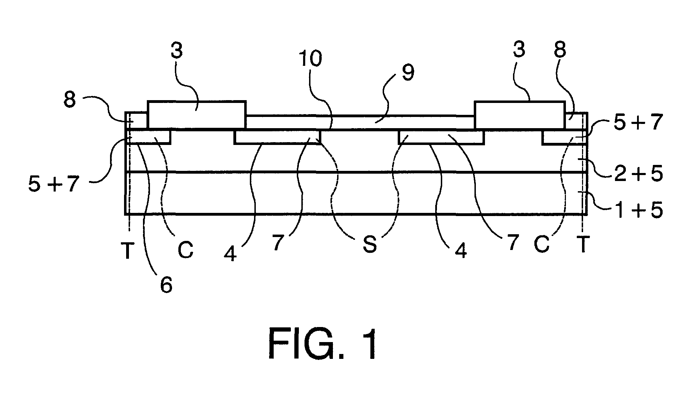

Gemäß Fig. 1 enthält ein Halbleiterbauelement ein Halbleitersubstrat 1 mit einem Dotierstoff eines ersten Dotierungstyps 5 mit einer ersten Dotierungsdichte n1 auf dem eine Epitaxieschicht 2 mit einem Dotierstoff eines ersten Dotierungstyps 5 mit einer zweiten Dotierungsdichte n2 aufgebracht ist. Auf der Epitaxieschicht 2 ist eine Isolatorschicht 3, welche beispielsweise SiO₂ enthält, mit einer Öffnung 10 abgeschieden Eine Schottky-Metallschicht 9 bedeckt die unter der Öffnung 10 liegende Epitaxieschicht 2. Ein ringförmiger Halbleiterbereich 4, Schutzring oder auch Guardring genannt, mit einem Dotierstoff eines zweiten Dotierungstyps 7 ist in der Epitaxieschicht 2 derart vorgesehen, dass er an der Isolatorschicht 3 und die Schottky-Metallschicht 9 in einem den Metall-Isolator-Übergang umgebenden Bereich angrenzt. In der Epitaxieschicht 2 ist entlang der Außenkontur des Halbleiterbauelementes ein Dotierungsbereich 6 mit einem Dotierstoff eines ersten Dotierungstyps 5 und einem Dotierstoff eines zweiten Dotierungstyps 7 eingebracht. Auf der Epitaxieschicht 2 ist entlang der Außenkontur des Halbleiterbauelementes eine Oxid-Schicht 8 aufgebracht, die an die Isolatorschicht 3 angrenzt. In der vorgegebenen Anordnung können beispielsweise das Halbleitersubstrat 1 und die Epitaxieschicht 2 Silicium enthalten. Als Dotierstoff eines ersten Dotierungstyps 5 kann beispielsweise P, As oder Sb und als Dotierstoff eines zweiten Dotierungstyps 7 kann zum Beispiel B, Al oder Ga verwendet werden. Dabei kann im Halbleitersubstrat 1 und in der Epitaxieschicht 2 der gleiche Dotierstoff oder jeweils ein unterschiedlicher Dotierstoff desselben Dotierungstyps eingesetzt werden. Die Schottky-Metallschicht 9 kann beispielsweise Al, Mo, W, Pt, Pd, Ag, Au, Ti, Ni, NiFe oder Kombinationen dieser Materialien enthalten.

Alternativ kann die Schottky-Metallschicht 9 auch so aufgebracht sein, dass sie einen Teil der Isolatorschicht 3 bedeckt.

Es kann auch eine Schutzschicht, beispielsweise aus Si₃N₄, auf der Isolatorschicht 3 und der Oxid-Schicht 8 aufgebracht sein.

Die elektrische Kontaktierung des Halbleiterbauelementes erfolgt an der Schottky-Metallschicht 9 und an der Rückseite des Halbleitersubstrats 1.

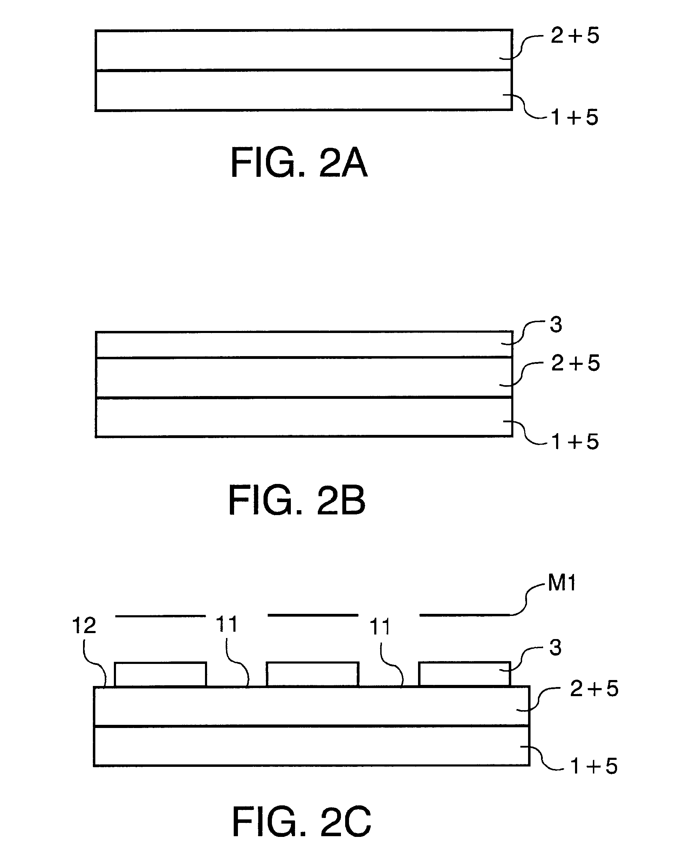

Zur Herstellung eines Halbleiterbauelementes wird gemäß Fig. 2A zunächst auf einem Halbleitersubstrat 1, welches beispielsweise Silicium und einen Dotierstoff eines ersten Dotierungstyps 5 wie zum Beispiel P, As oder Sb enthält, eine Epitaxieschicht 2 erzeugt. Die Epitaxieschicht 2 ist aus demselben Material wie das Halbleitersubstrat 1 und kann auch denselben Dotierstoff enthalten. Alternativ können die beiden Schichten unterschied liche Dotierstoffe des ersten Dotierungstyps enthalten. Die Dotierungsdichte n1 des Dotierstoffes eines ersten Dotierungstyps 5 im Halbleitersubstrat 1 ist größer als die Dotierungsdichte n2 des Dotierstoffes eines ersten Dotierungstyps 5 in der Epitaxieschicht 2. Anschließend wird eine Isolatorschicht 3, welche beispielsweise aus SiO₂ ist, abgeschieden (Fig 2B). Nach Auflegen einer Maske M1 werden in der Isolatorschicht 3 ein ringförmiger Bereich 11 und ein der Außenkontur des Halbleiterbauelementes angepasster Bereich 12 freigelegt (Fig. 2C). Nach diesem Prozessschritt sind die äußeren Ausmaße des Halbleiterbauelementes, die Trennbahn und der Channel sowie der aktive Bereich des Halbleiterbauelementes und der Schutzring festgelegt. Das Freilegen kann beispielsweise mittels Sputterverfahren, Plasmaätzens, physikalisch-chemischer Trockenätzverfahren oder einer chemischen Ätzlösung erfolgen.

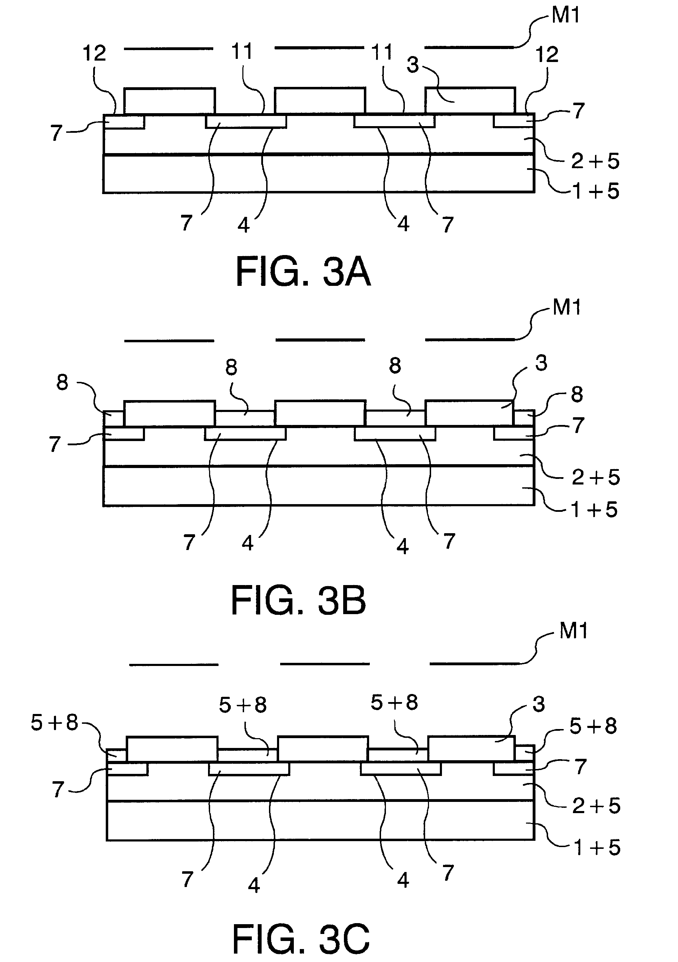

Im nächsten Schritt wird in die freigelegten Bereiche 11,12 der Epitaxieschicht 2 ein Dotierstoff eines zweiten Dotierungstyps 7 mit einer Dotierungsdichte n3 implantiert und eindiffundiert (Fig 3A). Der Dotierstoff eines zweiten Dotierungstyps 7 kann beispielsweise B, Al oder Ga enthalten. Anschließend wird auf die freigelegten Bereiche 11,12 der Epitaxieschicht 2 eine dünne Oxid-Schicht 8, welche beispielsweise SiO₂ enthält, abgeschieden (Fig 3B). Gemäß Fig 3C wird in die Oxid-Schicht 8 ein Dotierstoff eines ersten Dotierungstyps 5 mit einer Dotierungsdichte n4 implantiert. Die Dotierungsdichte n4 ist dabei größer als die Dotierungsdichte n3 des Dotierstoffes eines zweiten Dotierungstyps 7. Der Dotierstoff eines ersten Dotierungstyps 5 mit einer Dotierungsdichte n4 ist vorzugsweise derselbe Dotierstoff wie der Dotierstoff eines ersten Dotierungstyps 5 mit einer Dotierungsdichte n2 in der Epitaxieschicht 2.

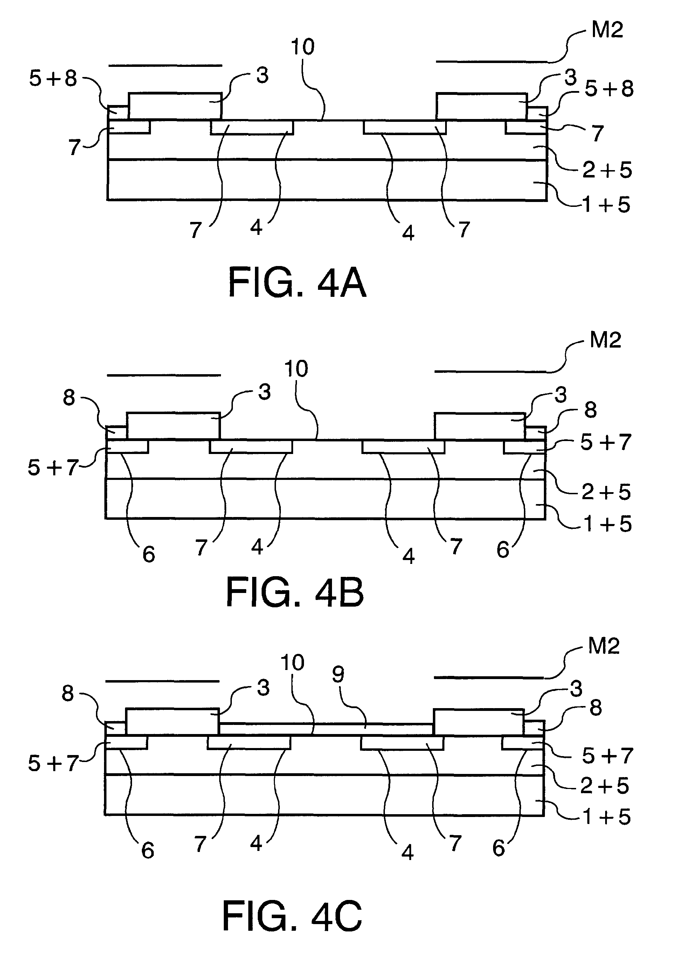

Unter Zuhilfenahme einer zweiten Maske M2 werden die Isolatorschicht 3 und die Oxid-Schicht 8, welche auch den implantierten Dotierstoff eines ersten Dotierungstyps 5 enthält, zur Schaffung einer Öffnung 10 in der aktiven Fläche des Halbleiterbauelementes beispielsweise mittels Ätzens entfernt (Fig. 4A). Der Dotierstoff eines ersten Dotierungstyps 5 in den verbliebenden Bereichen der Oxid-Schicht 8 wird in die Epitaxieschicht 2 eindiffundiert (Fig 4B). Dadurch entsteht ein Dotierungsbereich 6 mit dem Dotierstoff eines ersten Dotierungstyps 5 und mit dem Dotierstoff eines zweiten Dotierungstyps 7 entlang der Außenkontur des Halbleiterbauelementes, ein sogenannter Channel. Anschließend wird eine Schottky-Metallschicht 9 abgeschieden (Fig. 4C). Das Material für die Schottky-Metallschicht 9 ist beispielsweise Al, Mo, W, Pt, Pd, Ag, Au, Ti, Ni, NiFe oder Kombinationen dieser Materialien. Anschließend werden die einzelnen Halbleiterbauelemente getrennt. Dies kann beispielsweise mittels Sägens geschehen.

Es wird ein Halbleiterbauelement mit Trennbahn (T), Channel (C) und Schutzring (S) enthalten. Das so hergestellte Halbleiterbauelement kann beispielsweise eine Schottky-Hybrid-Diode sein.

Vor Abscheidung der Schottky-Metallschicht 9 kann alternativ auf der Isolatorschicht 3 und auf der Oxid-Schicht 8 eine Schutzschicht, beispielsweise aus Si₃N₄, unter Zuhilfenahme einer dritten Maske abgeschieden werden.

Im folgenden werden zwei Ausführungsformen der Erfindung erläutert, die eine beispielhafte Realisierungsmöglichkeiten darstellen.

### Ausführungsbeispiel 1

Ein Halbleiterbauelement mit Schutzring (S), Trennbahn (T) und Channel (C) weist ein Halbleitersubstrat 1 und eine Epitaxieschicht 2 aus Silicium jeweils mit Phosphor als Dotierstoff eines ersten Dotierungstyps 5 auf. Die Dotierungsdichte n2 in der Epitaxieschicht 2 ist kleiner als die Dotierungsdichte n1 im Halbleitersubstrat 1. Auf der Epitaxieschicht 2 ist eine Isolatorschicht 3 aus SiO₂ mit einer Öffnung 10 abgeschieden. Eine Schottky-Metallschicht 9 aus Al bedeckt die unter der Öffnung 10 liegende Epitaxieschicht 2. Ein ringförmiger Halbleiterbereich 4 mit Gallium als Dotierstoff eines zweiten Dotierungstyps 7 mit einer Dotierungsdichte n3 ist in der Epitaxieschicht 2 eingebracht. In der Epitaxieschicht 2 ist entlang der Außenkontur des Halbleiterelementes ein Dotierungsbereich 6 mit dem Dotierstoff eines ersten Dotierungstyps 5 Phosphor und dem Dotierstoff eines zweiten Dotierungstyps 7 Gallium eingebracht, der den Channel des Halbleiterbauelementes bildet. Dabei ist die Dotierungsdichte n4 des Phosphors größer als die Dotierungsdichte n2 und größer als die Dotierungsdichte n3 des Galliums. Auf der Epitaxieschicht 2 bzw. auf dem Dotierungsbereich 6 ist entlang der Außenkontur des Halbleiterbauelementes eine Oxid-Schicht 8 aus SiO₂ aufgebracht.

### Ausführungsbeispiel 2

Zur Herstellung einer Schottky-Hybrid-Diode wurde auf einem Halbleitersubstrat 1 aus Silicium mit Antimon als Dotierstoff eines ersten Dotierungstyps 5 eine Epitaxieschicht 2 aus Silicium mit Phosphor als Dotierstoff eines ersten Dotierungstyps 5 erzeugt. Die Dotierungsdichte n2 des Phosphors in der Epitaxieschicht 2 war geringer als die Dotierungsdichte n1 des Antimons im Halbleitersubstrat 1. Im nächsten Schritt wurde eine Isolatorschicht 3 aus SiO₂ abgeschieden, welche mittels Plasmaätzens und einer ersten Maske M1 derart strukturiert wurde, dass ein ringförmiger Bereich 11 und ein der Außenkontur der Diode angepasster Bereich 12 der Epitaxieschicht 2 freigelegt wurden. In die Epitaxieschicht 2 wurde als Dotierstoff eines zweiten Dotierungstyps 7 Bor mit einer Dotierungsdichte n3 implantiert und eindiffundiert. Anschließend wurde auf die freigelegten Bereiche 11,12 der Epitaxieschicht 2 eine dünne Oxid-Schicht 8 aus SiO₂ abgeschieden. In diese Oxid-Schicht 8 wurde als Dotierstoff eines ersten Dotierungstyps 5 Phosphor mit einer Dotierungsdichte n4, die größer als die Dotierungsdichten n2 und n3 war, implantiert. Mittels Plasmaätzens und einer zweiten Maske M2 wurde im aktiven Bereich der Diode die Isolatorschicht 3 und die Oxid-Schicht 8 entfernt, so dass eine Öffnung 10 entstand. Anschließend wurde der Phosphor aus der verbliebenen Oxid-Schicht 8 in die Epitaxieschicht 2 eindiffundiert, so dass entlang der Außenkontur der Diode ein Dotierungsbereich 6 mit Bor und Phosphor entstand Im nächsten Schritt wurde eine Schottky-Metallschicht 9 aus Aluminium abgeschieden. Anschließend werden die einzelnen Dioden mittels Sägen getrennt.

## Patentansprüche

1. Halbleiterbauelement, ausgestattet mit einem Halbleitersubstrat (1) mit einem Dotierstoff eines ersten Dotierungstyps (5) mit einer Dotierungsdichte n1, auf dem eine Epitaxieschicht (2) mit einem Dotieistoff eines ersten Dotierungstyps (5) mit einer Dotierungsdichte n2 aufgebracht ist, auf welcher eine Isolatorschicht (3) mit einer Öffnung (10) abgeschieden ist, mit einer die unter der Öffnung (10) liegende Epitaxieschicht (2) bedeckende Schottky-Metallschicht (9), mit einem in der Epitaxieschicht (2) befindlichen ringförmigen Halbleiterbereich (4) mit einem Dotierstoff eines zweiten Dotierungstyps (7) mit einer Dotierungsdichte n3, welcher an die Isolatorschicht (3) und die Schottky-Metallschicht (9) in einem den Metall-Isolator-Übergang umgebenden Bereich angrenzt, mit einem in der Epitaxieschicht (2) befindlichen Dotierungsbereich (6) mit einem Dotierstoff eines ersten Dotierungstyps (5) mit einer Dotierungsdichte n4 und dem Dotierstoff eines zweiten Dotierungstyps (7) mit einer Dotierungsdichte n3 entlang der Außenkontur des Halbleiterbauelementes und mit einer auf der Epitaxieschicht (2) befindlichen, an die Isolatorschicht (3) angrenzende, Oxid-Schicht (8) entlang der Außenkontur des Halbleiterbauelementes.

2. Halbleiterbauelement nach Anspruch 1,
**dadurch gekennzeichnet,**
**dass** die Dotierungsdichten n1 und n4 größer als die Dotierungsdichte n2 sind.

3. Halbleiterbauelement nach Anspruch 1,
**dadurch gekennzeichnet,**
**dass** die Dotierungsdichte n4 größer als die Dotierungsdichte n3 ist.

4. Halbleiterbauelement nach Anspruch 1,
**dadurch gekennzeichnet,**
**dass** das Material für das Halbleitersubstrat (1) und die Epitaxieschicht (2) Silicium enthält.

5. Halbleiterbauelement nach Anspruch 1,
**dadurch gekennzeichnet,**
**dass** der Dotierstoff eines ersten Dotierungstyps (5) ausgewählt aus der Gruppe P, As und Sb ist.

6. Halbleiterbauelement nach Anspruch 1,
**dadurch gekennzeichnet,**
**dass** der Dotierstoff eines zweiten Dotierungstyps (7) ausgewählt aus der Gruppe B, Al und Ga ist.

7. Halbleiterbauelement nach Anspruch 1,
**dadurch gekennzeichnet,**
**dass** die Isolatorschicht (3) und die Oxid-Schicht (8) SiO₂ enthalten.

8. Halbleiterbauelement nach Anspruch 1,
**dadurch gekennzeichnet,**
**dass** die Schottky-Metallschicht (9) ein Material ausgewählt aus der Gruppe Al, Mo, W, Pt, Pd, Ag, Au, Ti, Ni, NiFe und Kombinationen dieser Materialien enthält.

9. Halbleiterbauelement nach Anspruch 1,
**dadurch gekennzeichnet,**
**dass** auf der Isolatorschicht (3) und der Oxid-Schicht (8) eine Schutzschicht aufgebracht ist.

10. Halbleiterbauelement nach Anspruch 1,
**dadurch gekennzeichnet,**
**dass** das Halbleiterbauelement eine Schottky-Hybrid-Diode ist.

11. Verfahren zur Herstellung eines Halbleiterbauelement, ausgestattet mit einem Halbleitersubstrat (1) mit einem Dotierstoff eines ersten Dotierungstyps (5) mit einer Dotierungsdichte n1, auf dem eine Epitaxieschicht (2) mit einem Dotierstoff eines ersten Dotierungstyps (5) mit einer Dotierungsdichte n2 aufgebracht ist, auf welcher eine Isolatorschicht (3) mit einer Öffnung (10) abgeschieden ist, mit einer die unter der Öffnung (10) liegende Epitaxieschicht (2) bedeckende Schottky-Metallschicht (9), mit einem in der Epitaxieschicht (2) befindlichen ringförmigen Halbleiterbereich (4) mit einem Dotierstoff eines zweiten Dotierungstyps (7) mit einer Dotierungsdichte n3, welcher an die Isolatorschicht (3) und die Schottky-Metallschicht (9) in einem den Metall-Isolator-Übergang umgebenden Bereich angrenzt, mit einem in der Epitaxieschicht (2) befindlichen Dotierungsbereich (6) mit einem Dotierstoff eines ersten Dotierungstyps (5) mit einer Dotierungsdichte n4 und dem Dotierstoff eines zweiten Dotierungstyps (7) mit einer Dotierungsdichte n3 entlang der Außenkontur des Halbleiterbauelementes und mit einer auf der Epitaxieschicht (2) befindlichen, an die Isolatorschicht (3) angrenzende, Oxid-Schicht (8) entlang der Außenkontur des Halbleiterbauelementes, welches mindestens die Schritte
- Erzeugen einer Epitaxieschicht (2) mit einem Dotierstoff eines ersten Dotierungstyps (5) mit einer Dotierungsdichte n2 auf einem Halbleitersubstrat (1) mit einem Dotierstoff eines ersten Dotierungstyps (5) mit einer ersten Dotierungsdichte n1,
- Abscheiden einer Isolatorschicht (3) auf der Epitaxieschicht (2),
- Freilegen eines ringförmigen Bereichs (11) und eines der Außenkontur des Halbleiterbauelementes angepassten Bereichs (12) in die Isolatorschicht (3),
- Implantieren eines Dotierstoffes eines zweiten Dotierungstyps (7) mit einer Dotierungsdichte n3 in die freigelegten Bereiche (11,12) der Epitaxieschicht (2),
- Diffusion des Dotierstoffes eines zweiten Dotierungstyps (7) in die Epitaxieschicht (2),
- Abscheiden einer Oxid-Schicht (8) auf die freigelegten Bereiche (11,12) der Epitaxieschicht (2)
- Implantieren eines Dotierstoffes eines ersten Dotierungstyps (5) mit einer Dotierungsdichte n4 in die Oxid-Schicht (8),
- Freilegen einer Öffnung (10) in der Isolatorschicht (3),
- Diffusion des Dotierstoffes eines ersten Dotierungstyps (5) aus der Oxid-Schicht (8) in die Epitaxieschicht (2),
- Abscheiden einer Schottky-Metallschicht (9)
- und Trennen entlang der Außenkontur des Halbleiterbauelementes umfasst.

12. Verfahren zur Herstellung eines Halbleiterbauelementes nach Anspruch 11,
**dadurch gekennzeichnet,**
**dass** bevor die Schottky-Metallschicht (9) abgeschieden wird, eine Schutzschicht auf der Isolatorschicht (3) und der Oxid-Schicht (8) abgeschieden wird.
